Europäisches Patentamt

European Patent Office

Office européen des brevets

(11) Publication number: **0 421 708 A2**

# EUROPEAN PATENT APPLICATION

(21) Application number: 90310730.8

(22) Date of filing: 01.10.90

(51) Int. Cl.5: **H03J 5/24**

(30) Priority: 03.10.89 GB 8922205

(43) Date of publication of application:
10.04.91 Bulletin 91/15

(84) Designated Contracting States:
AT BE CH DE DK ES FR GB GR IT LI LU NL SE

(71) Applicant: **PDS ELECTRONICS LIMITED**
**134 Clayton Road, Hayes**
**Middlesex, UB3 1BB(GB)**

(72) Inventor: **Boehmlaender, Thomas**
**15 Stretton Lodge, 111 Gordon Road**
**Ealing, London Q13 8PE(GB)**
Inventor: **Scott, Michael**
**402 Lansbury Drive**
**Hayes, Middlesex, UB4 8SP(GB)**

(74) Representative: **Skone James, Robert Edmund**
**GILL JENNINGS & EVERY 53-64 Chancery**
**Lane**
**London WC2A 1HN(GB)**

(54) **Frequency converting device.**

(57) Frequency converting device particularly for satellite television receivers to expand the available receiving range to include channels in the bands 950MHz to 1120MHz and 1145MHz to 1750MHz by frequency converting the received channels to frequencies acceptable to the existing receiver (in the range 1120MHz to 1145MHz). The frequency converting device is attached to the front end of the existing receiver after the receiving aerial.

# FREQUENCY CONVERTING DEVICE

This invention relates to frequency converting devices, in particular for satellite television receivers.

In the field of satellite television there exist receivers for receiving transmissions in the frequency band 1120MHz to 1145MHz corresponding to those frequencies generated by the ASTRA satellite. They are capable of receiving 16 channels in this frequency band. It is proposed that future additional Astra Satellites will transmit additional channels in the bands 950MHz to 1120MHz and 1145MHz to 1750MHz which some existing receivers cannot receive.

In accordance with the present invention we provide a frequency converting device for attachment to a multi-channel receiver capable of being tuned to a number of different frequency channels within a frequency band of 1120MHz-1145MHz, the frequency converting device including frequency shift means adapted to shift the frequencies of an incoming multi-channel signal in which the channel frequencies fall outside the predetermined frequency band but within the range 950MHz to 1750MHz, into the frequency band 1120MHz-1145MHz to enable the receiver to be tuned to each of the channels in the incoming signal.

The advantage of this device is that the existing receiver can be used without modification to receive an expanded range of channels. The new device is inserted in the line between the antenna and the receiver using standard connections, which is attractive for the user.

Preferably, the frequency converting device comprises an input for receiving the multi-channel input signal and an output for connection to a receiver in use, and two parallel signal paths extending between the input and output, one of which contains frequency shift means, and control means for selectively connecting either path between the input and output.

Preferably, the control means comprise a Radio Frequency switch and the frequency shift means include a double balanced modulator which combines an appropriate local oscillator frequency with the incoming signal and outputs a signal with a frequency in the range 1120MHz to 1145MHz.

Typically, the frequency shift means incorporates in series an input filter stage, an amplification stage, a mixer, an output filter stage and a further amplification stage, and a variable frequency local oscillator connected to the mixer. The passband filters are typically in the ranges 950MHz-1120MHz and 1145MHz-1170MHz in the input filter stage and 1120MHz-1145MHz in the output filter stage so that only frequencies in the defined frequency bands are allowed through the device.

Preferably, the Radio Frequency switch deselects the filter and mixer path and selects the other (bypass) path when a high potential is applied.

Typically, the frequency converting device will be part of a satellite receiving system comprising a satellite receiving dish, a frequency converting device according to the invention for receiving signals from the dish, and a multi-channnel receiver connected to the converting device and capable of being tuned to a number of different channels in the frequency band 1120MHz-1145MHz.

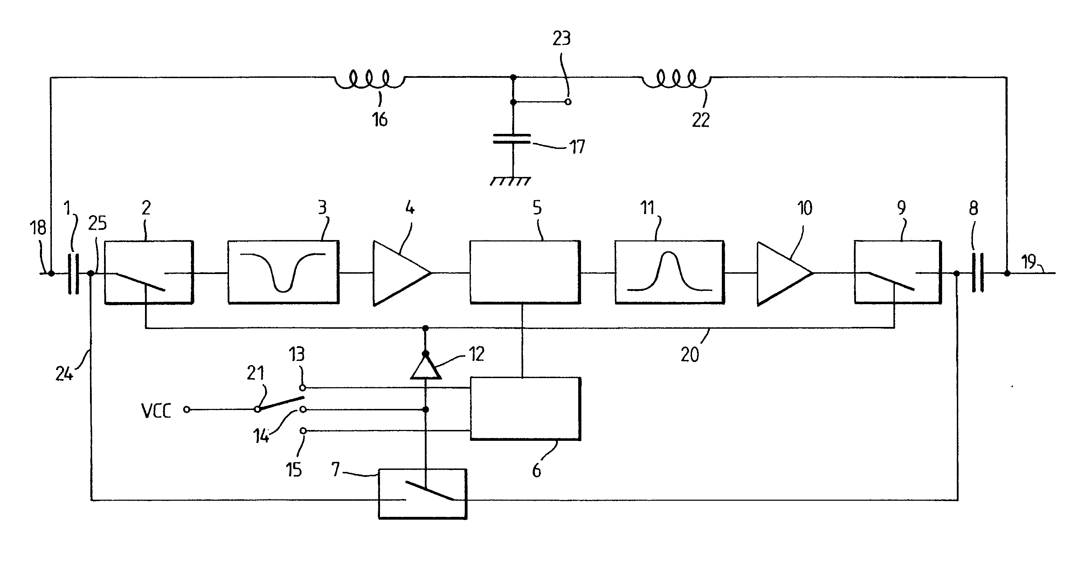

An example of a frequency converting device according to the present invention will now be described with reference to the accompanying drawing which is a block diagram of the device.

The device consists of an input 18 to a capacitor 1 from a satellite receiving dish (not shown), the capacitor 1 also being connected to a pair of switches 2, 7. One switch 2 at the start of a frequency shift means path 25 is connected to an A and B passband filter 3, while the other 7 is a band select switch in a bypass path 24 which, when closed, connects the input capacitor 1 directly to an output capacitor 8. A manually operated multi-way switch 21 couples a supply voltage selectively to either A, B or C band inputs. A, B and C bands are defined as being 950MHz-1120MHz, 1120MHz-1145MHz and 1145MHz-1170MHz respectively.

A and B band terminals 13, 15 connect to a high/low local oscillator 6 whose output is mixed with the output of the A and B passband filter 3, which has been amplified by an amplifier 4, in a double balanced mixer 5. The C band terminal 14 is connected to an inverter 12

The output of the double balanced mixer 5 passes through a C passband filter 11 to another amplifier 10 and a switch 9 to the output capacitor 8 which is connected to the receiver section through the output 19.

The position of switches 2, 7, 10 is controlled by the multi-way switch 21. When this switch is coupled to the C band terminal 14 the high supply voltage Vcc is supplied to the switch 7 thus closing the switch while the voltage is inverted by inverter 12 so that switches 2, 9 are opened. When the switch 21 is connected to the A or B terminals 13, 15, the potential applied to the switch 7 goes low, thus opening the switch, while the inverted potential goes high, thus closing switches 2, 9.

The incoming signal from the receiving dish passes through an input capacitor (not shown) to remove any dc terms, into a switch. When it is desired to frequency convert the signal the switch 21 will be set to the appropriate band (A or B) thus causing the signal to be fed into the path 25. After passing through the filter 3, the filtered signal is amplified by 10dB by the amplifier 4 and then mixed in the double balanced mixer 5 with the frequency output from the local oscillator (LO) 6. The purpose of amplifying the signal is to make up for losses as it passes through the filtering (and mixing) stages of the frequency conversion. The higher LO frequency will be selected for A band signals, and the lower LO frequency for B band so that both A and B band signals will be converted into C band signals. The mixed signal is filtered by the C band filter 11 and then amplified by a further 10dB by the amplifier 10. The signal then passes through the output capacitor 8 to the receiver (not shown).

When there is no need for frequency conversion the switch 21 will designate band C selection 14 as the input band which means that the input signal bypasses the filters and mixing stage of the path 25 and is fed along path 24 to emerge through the output capacitor 8 to the receiver in the form it entered the frequency conversion module but free of dc components.

There is a supply, νcc 23 to the system which is provided with high frequency noise suppression by the arrangement of the capacitor 17 and inductors 16, 22.

## Claims

1. A frequency converting device for attachment to a multi-channel receiver capable of being tuned to a number of different frequency channels within a frequency band of 1120MHz to 1145MHz, the frequency converting device including frequency shift means adapted to shift the frequencies of an incoming multi-channel signal, in which the channel frequencies fall outside this frequency band, but within the range 950MHz to 1750MHz, into frequencies in this frequency band 1120MHz to 1145MHz to enable the receiver to be tuned to each of the channels in the incoming signal.

2. A frequency converting device according to claim 1, comprising an input (18) for receiving the multi-channel input signal and an output (19) for connection to a receiver in use, and two parallel signal paths (24,25) extending between the input (18) and output (19), one of which contains the frequency shift means (25), and control means (21) for selectively connecting either path between the input and output.

3. A frequency converting device according to claim 2, in which the control means is a Radio Frequency switch.

4. A frequency converting device according to claim 3, in which the Radio Frequency switch (21) deselects the frequency shift means path (25) and selects the other path (24) in response to a high potential.

5. A frequency converting device according to any of the preceding claims, wherein the frequency shift means comprises in series an input filter stage (3), an amplification stage (4), a mixer (5), an output filter stage (11) and a further amplification stage, and a variable frequency local oscillator (6) connected to the mixer (5).

6. A frequency converting device according to claim 5, in which the input filter stage (3) is a passband filter to pass frequencies of 950MHz-1120MHz and 1145MHz to 1170MHz.

7. A satellite receiving system comprising a satellite receiving dish, a frequency converting device according to any of the preceding claims for receiving signals from the dish and a multi-channnel receiver connected to the converting device and capable of being tuned to a number of different channels in the frequency band 1120MHz-1145MHz.